# EUROPEAN PATENT SPECIFICATION

(11) **EP 0 581 723 B1**
(45) Date of publication and mention of the grant of the patent: **19.09.2001**
(21) Application number: 93650027.1
(22) Date of filing: 28.07.1993
(51) Int. Cl.: G06F 9/44, G06F 17/50

(54) **An automatic design process and apparatus**
Verfahren und Vorrichtung zum automatischen Entwerfen
Procédé et dispositif pour conception automatique

(30) Priority: 31.07.1992 IE 253092
(43) Date of publication of application: 02.02.1994
(73) Proprietor: HITACHI EUROPE LIMITED, Maidenhead, Berkshire, SL6 8YA (GB)
(72) Inventor: Cunningham, Padraig, Dr., Dublin 4 (IE); Smyth, Barry, Dublin 16, (IE)
(74) Representative: O'Connor, Donal Henry

(56) References cited:
- ARTIFICAL INTELLIGENCE IN DESIGN '91, June 1991 , OXFORD,UK pages 137 - 150 MAHER AND ZHANG 'CADSYN: using case and decomposition knowledge for design synthesis'
- A.I. FOR ENGINEERING DESIGN, ANALYSIS AND MANUFACTURING, vol. 3, no. 2 , 1989 pages 111 - 123 HOWARD ET AL. 'Applying design-dependent knowledge in structural engineering'
- ENGINEERING APPLICATIONS OF ARTIFICIAL INTELLIGENCE vol. 5, no. 4 , July 1992 pages 275 - 287 HUNT AND LEE 'Towards a knowledge-based design assistant'
- INTERNATIONAL WORKSHOP ON A.I. FOR INDUSTRIAL APPLICATIONS 1988 pages 85 - 90 ONO ET AL. 'Artificial intelligence based programmable controller software designing'
- IEEE EXPERT vol. 3, no. 4 , 1988 , NEW YORK, US, pages 9 - 18 LUQI 'Knowledge-based support for rapid software prototyping'

## Description

The invention relates to an automatic design process and apparatus, the process comprising the steps of storing design data, retrieving the data, and generating a target solution being an item design. The items include programmed computer devices and mechanical or electro-mechanical items.

Heretofore, attempts have been made at automatic design of items. For example, European Patent Specification No.
EP-A2-0343682 (Mitsubishi) describes an automatic programming system in which efficiency of testing is improved by coupling of design and test stages. It appears that this process has a narrow range of uses because it is restricted to development of computer programs, and indeed a particular type of computer program. This is because a very large amount of knowledge must be stored because development and design is from "first principles".

British Patent specification No. GB-B-2187004 (STC) describes an automatic inspection system in which existing signal processing modules are selected to construct a target system for a particular use. However, in many circumstances it is not possible to make use of a library of existing modules, one of which is ideally suitable for a particular target product. In these cases, adaptation of existing modules is required and where this is the case, the tendency has been for development to be carried out manually, using human intuition.

It is known to have an automatic case-based design system including the steps of inputting a target specification into a memory circuit, automatically finding a best-fit case in a case-base, retrieving the case and adapting it to conformity with the target specification to provide a solution. This, for example is described in ARTIFICIAL INTELLIGENCE IN DESIGN '91, June 1991, Oxford, UK, Pages 137-150, MAHER AND ZHANG 'CADSYN: using case and decomposition knowledge for design

synthesis' and A.1. FOR ENGINEERING DESIGN, ANALYSIS AND MANUFACTURING, vol. 3, no. 2, 1989 pages 111-123 HOWARD ET AL. 'Applying design-dependent knowledge in structural engineering'. The former document is a relatively good description of the general prior art known heretofore and the latter document describes a system in which there is case-based reasonong integrated with rule-based reasoning. The case-based and the rule-based approaches compete during the problem solving process.

The invention is directed towards providing a process and apparatus for the automatic design or development of products, which process has the versatility of human expertise but carries out the task much more efficiently.

A related object is that the circuits and memory devices of data processing apparatus' be both initially configured and subsequently operated for an efficient automatic design process.

According to one aspect of the invention there is provided
an automatic case-based design process of the type comprising storing design data on a case-base in a memory circuit, preparing a target specification defining an item to be designed, writing the target specification to the memory circuit, automatically locating an address for a case and retrieving a closest fitting case in the case-base and adapting the retrieved case to the target specification to provide a solution, characterised by,
the memory circuit comprising a plurality of panels at least some of said panels being for the temporary storage of data, and at least some of said panels having each at least one processing agent associated with them,
writing of data into one of said panels causing the triggering of the at least one associated processing agent,
initialising the process by writing a target specification defining an item to be designed to a predetermined panel, whereby a case is retrieved from the case-base and written to another panel,
and by carrying out successive cycles of adapting said case and rewriting the adapted case to another panel until the target solution is achieved.

In one embodiment, cases of the case-base have a partonomic, decomposable, structure formed of link descriptions, and the step of writing a target specification of an item component involves writing a link description of a retrieved and adapted decomposable case.

Ideally, the memory circuit comprises an adaptation panel to which the adapted cases are written, and a solution panel, and the adapted case is integrated with other parts of the target solution after said adapted case is written to the adaptation panel.

In one embodiment, the case-base has a taxonomic structure, and the step of automatically determining an address for a case comprises the sub-step of referencing classification features of the target specification. In this embodiment, cases in the case-base are preferably linked by a partonomic structure, and there is a further sub-step of referencing internal features of the target specification to select a closest-match case for retrieval.

Ideally, the step of writing the retrieved case to the memory circuit comprises the sub-steps of automatically identifying differences between the retrieved case and the target specification, and writing the differences as mapping links to a panel of the memory circuit for reference during adaptation.

In the latter embodiment the process preferably comprises the further sub-step of, for each mapping link describing a discrepancy between a target specification and a retrieved case, identifying a pre-stored adaptation module for adaptation of the case for that discrepancy.

In another embodiment, the step of writing a target specification to the memory circuit comprises the sub-steps of receiving from a user and writing a decomposable target specification to a partitioned section of the memory circuit, and subsequently automatically analysing the decomposable target specification and writing the resultant detailed target specification to another partitioned section of the memory circuit, the detailed target specification being subsequently used in the design process.

According to another aspect of the invention there is provided
an automatic case-based design apparatus of the type comprising:
a memory circuit for storing design data on a case-base,
means for generating a target specification for defining an item to be designed and storing it in the memory circuit;
a retrieval processor for automatically determining an address for a case in the case-base by reference to the target specification in the memory circuit and retrieving the closest fitting case,
an adaptation processor for adapting the retrieved case into conformity with the target specification,
characterised by,
the memory circuit comprising a plurality of panels at least some of said panels being for the temporary storage of data, and at least some of said panels having each at least one processing agent associated with them,
by means for causing the triggering of the at least one processing agent when data is written into the associated one of said panels,
means for initiallising the process by writing a target specification defining an item to be designed to a predetermined panel, whereby a case is retrieved from the case-base, and written into another panel,
and by means for carrying out successive cycles of adapting said case and rewriting the adapted case to another panel until the target solution is achieved.

In one embodiment, the apparatus further comprises a decomposition processor comprising means for reading portion of the solution in the panel of the memory circuit, and writing said portion to a target specification panel of the memory circuit so that a further cycle of retrieval and adaptation is initiated.

In a further embodiment, the apparatus further comprises an analysis processor comprising means for reading a decomposable target specification to generate a detailed target specification, and means for writing the detailed target specification to a panel.

The invention will be more clearly understood from the following description of some embodiments thereof, given by way of example only with reference to the accompanying drawings in which:
Fig. 1 is a diagrammatic view showing an automatic design apparatus of the invention;
Fig. 2 is a diagrammatic view of an industrial control situation for which a controller may be designed;
Fig. 3 is a diagram showing a case-base forming part of the apparatus;
Fig. 4 is a diagram showing portion of the case-base;
Figs. 5, 6 and 7 are diagrams showing contents of a memory circuit of the apparatus during operation of the process; and
Fig. 8 is a representation of a solution generated by the process and apparatus of the invention.

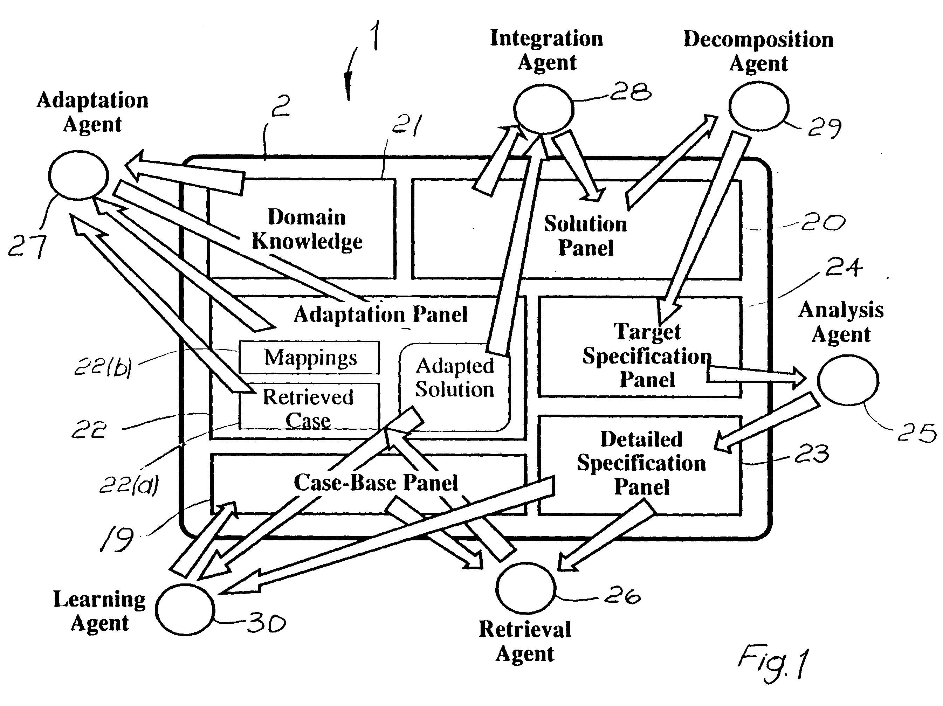

Referring to the drawings, and initially to Fig. 1 there is illustrated an apparatus 1 of the invention for the carrying out of an automatic design process. The items which could be designed by the process include devices programmed with software code for control of industrial process equipment, or alternatively design of a vehicle or other item. In the examples which follow, the invention is described for automatic generation of programmed devices for carrying out various tasks. It will be appreciated, however, that the invention applies to any other type of design problem. Indeed, this is one of the major advantages of the invention.

The apparatus 1 comprises a random access memory 2, part of which is illustrated in Fig. 1. The memory 2 may be of any suitable size to suit the nature of automatic design operations and is partitioned into various sections or panels 19 to 24. The apparatus 1 also comprises a set of processing agents 25-30 which comprise software functions or modules, but could alternatively be hardware circuits. An important aspect of the invention is the manner in which the agents operate in an automatic, self-activated manner in writing data to, or reading data from the memory 2. Another important aspect is the pre-defined general structure of the memory 2. These aspects are explained in more detail below.

In more detail, the memory 2 comprises two main types of structure, as follows:-
(a) partitioned sections or panels 20, 22, 23 and 24 for temporary storage of data for a particular design process; and
(b) a partitioned section or panel 19 storing a case-base 10, and a domain knowledge panel 21, which are permanent. The memory 2 may have a set of non-volatile locations for storage of the case-base 10 and a domain model, or it may be written from a fixed storage device such as a fixed disk at the start of each design process.

In this specification, the term "memory circuit" means the group of memory devices (or single device) addressable by processors of the apparatus 1.

In broad outline, an automatic design process involves retrieval of a relevant prior solution case from the case-base 10, and the agents generating a target solution by writing data to and reading data from the memory 2. The agents are activated by monitoring the particular panels of the memory 2 being used. A panel may be segmented into different memory location sets, called keys. Operation of the agents 7 involves dynamic allocation of memory locations on an "as required" basis. Accordingly, the term "partitioned" includes such dynamic allocation.

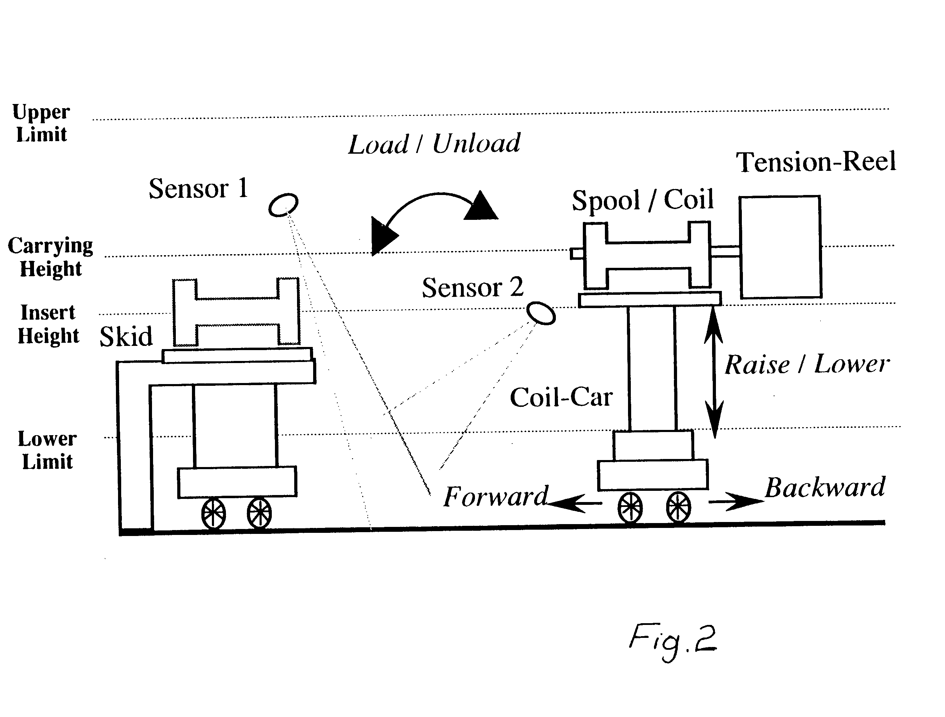

Fig. 2 shows an industrial control environment for which software code is to be generated by operation of the apparatus 1. The software code is for a robotic controller in this environment.

In this example, the automatic design process is to generate plant control software code for controlling autonomous vehicles in a steel mill for loading and unloading of metal coils during the milling process. The target software code should control unloading of a spool from a tension reel to a loading bay (a skid) using a two-speed buggy. Two sensors, namely sensor 1 and sensor 2 are used. The steps involved in this operation include movement of the buggy to the tension reel and alignment with the spool. The spool Is released onto the buggy, which can then transport its load to the skid before releasing it onto the skid platform. Vehicle control is achieved by sensor activity. For example, in order to move the buggy to the tension reel, it is first set in motion, then at some later time the sensor indicating arrival at the tension reel is activated, causing the buggy to stop. This action is captured in a code section referred to as Forward*1.

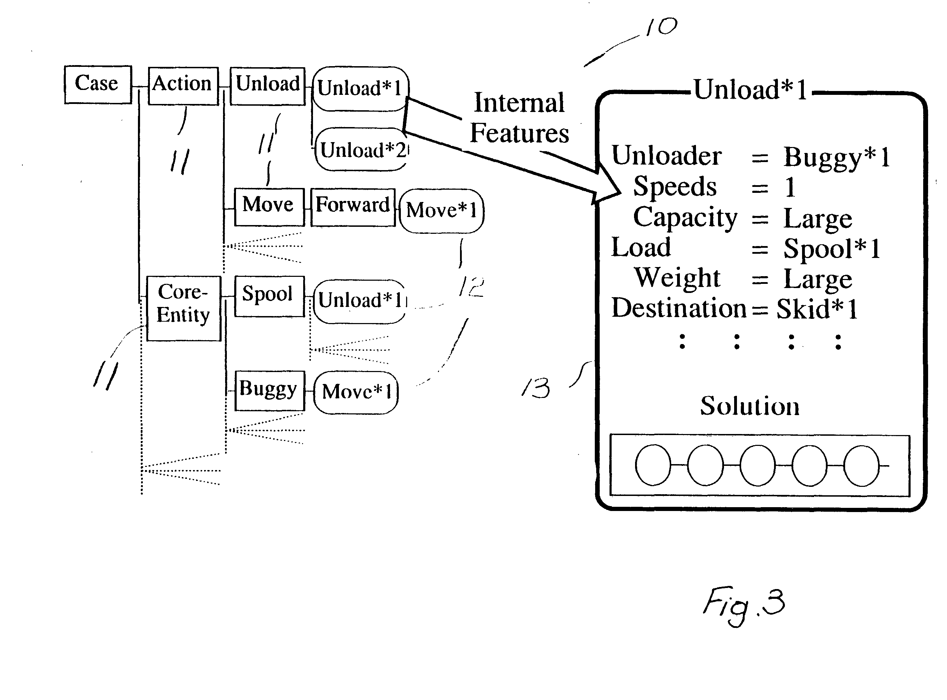

The case-base 10 is illustrated in more detail in Fig. 3. The case base 10 comprises a taxonomic ("is a") structure of (rectangular) classification nodes 11 which are interlinked according to their classification features. The classification nodes 11 form paths to (rounded) case nodes 12, each of which contains data for a specific software code module which has previously been generated for a particular target specification. Each case node 12 has a number of internal features and is also associated with a number of classification features. The set of classification features for each node 12 defines paths to the node 12 within the case-base 10. A set of internal features of each case node 12 may be regarded as attributes and these are added to as new paths to the node are developed. The right-hand portion of Fig. 3 shows a set of internal features 13 for the case node 12 referred to as Unload*1.

Each classification node 11 has a stored set of associated internal features. For example, the classification node "Unload" has internal features "Unloader", "Load", and "Destination" associated with it. Each case node 12 stores all of the internal features of the classification nodes 11 which define the path(s) to it. Thus, the case node "Unload*1" has the internal feature "Load" from the classification node "Unload", the internal feature "Weight" from the classification node "Spool", and the internal feature "Speeds" from the classification node "buggy". When the internal feature is stored in a case node 12 it is instantiated i.e. give a value. For example the internal feature "Weight" in the case node "Unload*1" has the value "Large".

These cases have a partonomic structure which in this embodiment includes decomposable top level cases (TLCs) and a number of detailed cases (DCs). However, it is envisaged that intermediate levels may also be included, if required.

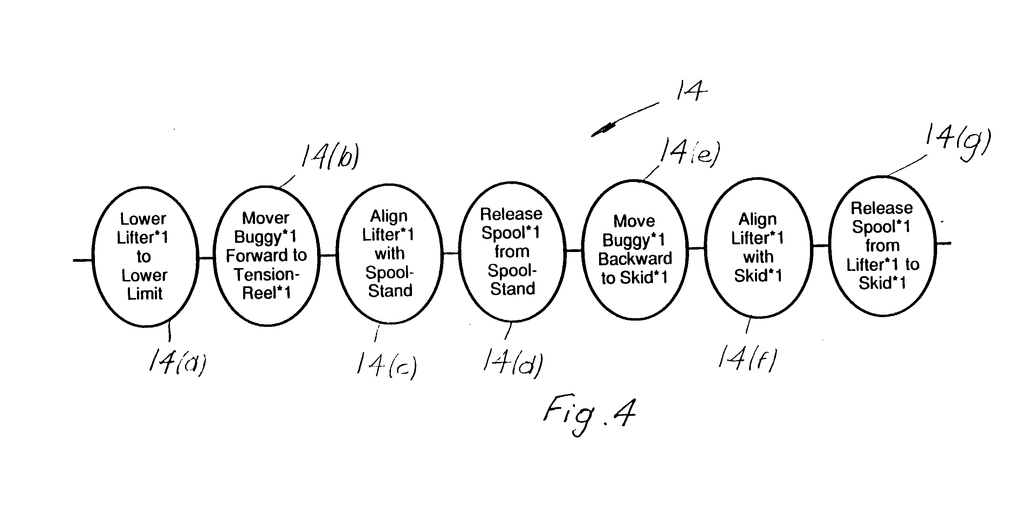

A decomposable top level case 14 is shown in Fig. 4. It will be noted that the top level case does not reference the detailed cases directly - instead, link descriptions (14(a) to 14(g)) are used which define the parameters of the appropriate detailed case. These links allow for greater flexibility during the automatic design process by providing access to all detailed cases in the case-base for efficient automatic selection of which best fits the current situation. An important aspect of the automatic design process is that a decomposable top level case adaptation involves retrieving and adapting detailed cases which correspond to the top level case link descriptions. A possible disadvantage of this feature is that a considerable control problem for the automatic design process may be introduced. The following description of the automatic process shows how this control problem does not arise.

Referring again to Fig. 1 arrows between the various agents 25 to 30 and panels 19 to 24 help to illustrate the automatic design process of the I invention. The memory circuit 2 includes a solution panel 20 which at the beginning of any process is empty and thus, the solution panel 20 is simply a set of memory locations which have been mapped for a particular use. There is a domain knowledge panel 21 for storage of user-inputted data for the particular design task and/or a general domain model. Further, there is an adaptation panel 22 which includes a retrieved case key 22(a), a mappings key 22(b) and an adapted solution key 22 (c). These keys or sub-panels are all empty at the start of the process and are simply partitioned initially for their particular uses. Other sets of locations of the memory circuit 2 which have been mapped to act as panels for temporary holding of data include a detailed specification panel 23 and a target specification panel 24.

The set of agents 25 to 30 of the apparatus 1 include an analysis agent 25, a retrieval agent 26, an adaptation agent 27, an integration agent 28, a decomposition agent 29 and a learning agent 30. Operation of these agents is described below.

For initialisation of the apparatus 1, the case-base panel 19 is set to store the case-base. Thus, the panel 19 may be non-volatile, or if volatile, be initially written to from disk. The domain knowledge panel 21 usually stores general design data inputted previously by the user as domain knowledge. The remaining panels are cleared. The design process is then initiated by writing a target specification to the panel 24. This is a decomposable high-level description in a pre-defined format of the design task.

The agents 25 to 30 are activated in an opportunistic or automatic manner by communication with a write function, not shown. An agent instructs the write function to carry out a write operation, this instruction including the relevant panel key. The write function then refers to a cross-reference table stored in non-volatile memory and uses it to determine associated agents, and the timing for their activation. According to this information, the write function transmits a signal to the associated agents either before or after writing the data to the panel. When the write function is carrying out the write operation, a memory controller (not shown) dynamically allocates the required memory locations.

As stated above, after initialisation, a high-level, or decomposable target specification is written to the panel 24. This had been inputted by the user initially. Subsequently, the analysis agent 25 reads the high-level target description from the panel 24 and transforms it into a more detailed frame-based description. This transformation process involves the retrieval of all knowledge pertinent to the target problem and the result is a frame representation of the target specification with additional details retrieved from the domain model 6. The detailed specification is written to the detailed specification panel 23.

Subsequently, the retrieval agent 26 reads the detailed specification and identifies classification features within it. It then uses the classification features to form a path via the classification nodes 11 in the case-base 10 to one or more case nodes 12. Subsequently, the retrieval agent 26 identifies internal features in the panel 23 and by comparing with those of the accessed case nodes, it determines the closest match case. This is then retrieved. Mapping links identifying differences and similarities between the detailed specification and the retrieved case are determined. Associated with the mapping links identifying differences are adaptation modules which cater for these differences. This means that during retrieval, adaptation modules are identified which can perform the modifications necessary to transform the retrieved case into confirmation with the specification detailed. The case is then written to the retrieved case sub-panel 22 (a) in the adaptation panel 22, and the mapping links are written to the mappings sub-panel 22(b).

Typically, a retrieved case will not satisfy the requirements of the target problem and accordingly adaptation is required.

In the invention, the adaptation steps are carried out in both an automatic and possibly interactive manner.

Operation of the adaptation agent 27 involves initially performing a rudimentary adaptation of the retrieved case using the mappings so that it confirms as closely as possible to the target specification. The adaptation agent 27 includes several sub-processors each of which is constructed to carry out subsequent automatic adaptation using domain knowledge captured in the panel 21 to perform a more detailed adaption of the retrieved case, the result of which is generally referred to as an adapted solution. If, after automatic adaptation, the adapted solution still does not conform to the target specification, interactive adaptation may be used. This aspect of the invention ensures maximum flexibility in that while in many cases a solution would be generated automatically, user interaction is allowed where required to ensure that a correction solution is obtained.

Operation of the decomposition agent 29 involves simply taking each link description of an adapted top level decomposable case and writing it in turn to the target specification panel 24 so that further analysis, retrieval and adaptation cycles are invoked. The integration agent 28 operates to integrate each newly adapted solution component into the overall solution structure in the solution panel 20.

The objective of the learning agent 30 is to store newly generated cases inn the case-base 10 for use during subsequent processes. The learning agent 30 functions after the adaptation agent 27 or the user has modified the retrieved case so that it conforms exactly to the target specification, and it monitors the adapted solution key of the adaptation panel 22. When the modified solution is written to this memory location (by the adaptation agent 27) the learning agent 30 is activated.

The learning agent 30 reads the modified solution and also the detailed specification (classification and internal features) from the detailed specification panel. The learning agent 30 then combines the detailed specification data and the solution data to form a new case representing the solution just generated. The learning agent 30 stores this new case in the case-base 10 at the correct location. This location is found by using the new case's classification features to find a set of paths through the case-base (similar to retrieval). The learning agent 30 writes the new case at those memory positions pointed to by these paths.

The domain knowledge panel 21 and the case-base panel 10 may require in excess of 1MB of memory, whereas the other panels typically require between 5 and 50KB of memory.

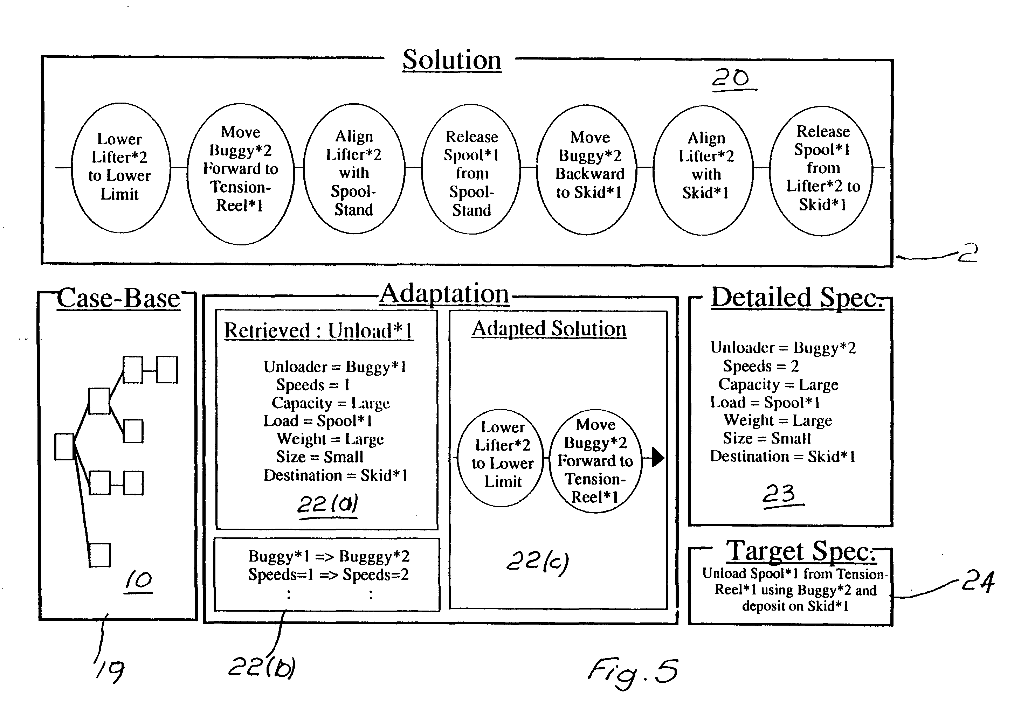

Reference is now made to the example of Fig. 2 to more clearly explain the process. In the automatic design process, there is a first cycle which is illustrated in Fig. 5. The cycle starts with the target specification being initially written to the panel 24. This is transformed by the analysis agent 25 into the frame structure of internal features shown in the detailed specification panel 23. Activation of the retrieval agent 26 causes the top level case referred to as Unload*1 (see also Fig. 3) to be retrieved and placed in the retrieved case sub-panel 22 (a). This retrieved case is similar to the target specification except that instead it uses Buggy*1, a one speed buggy, rather than Buggy*2, a two speed buggy. This discrepancy is captured by the retrieval agent 26 and is written to the mapping sub-panel 22(b). Thus an adaptation module is identified which can modify a 1 speed buggy into a 2 speed buggy. In turn, the adaptation agent 27 reads the contents of the mappings sub-panel 6 and uses this information to change the link description of Unload*1 appropriately, as can be seen in the adapted solution sub-panel 22(c). The adapted top level case is read by the integration agent 28 and is written to the solution panel 20.

Having established a decomposable top level case to use as a decomposition/integration template, the process continues in subsequent cycles by retrieving and adapting a new (detailed) case for each component of the, decomposable, top level case.

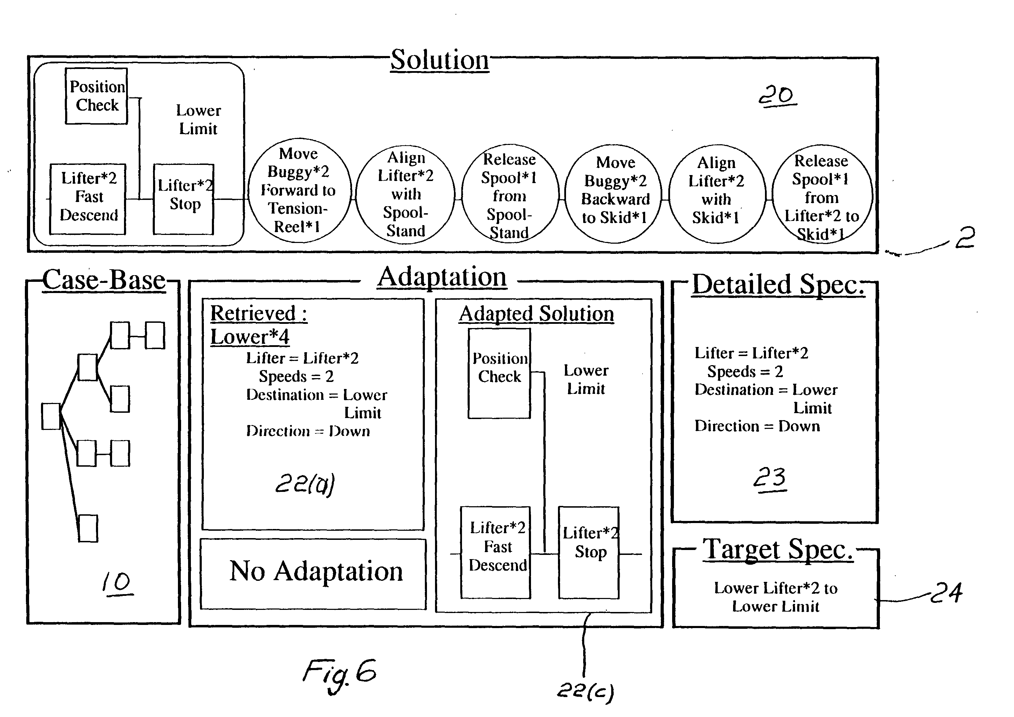

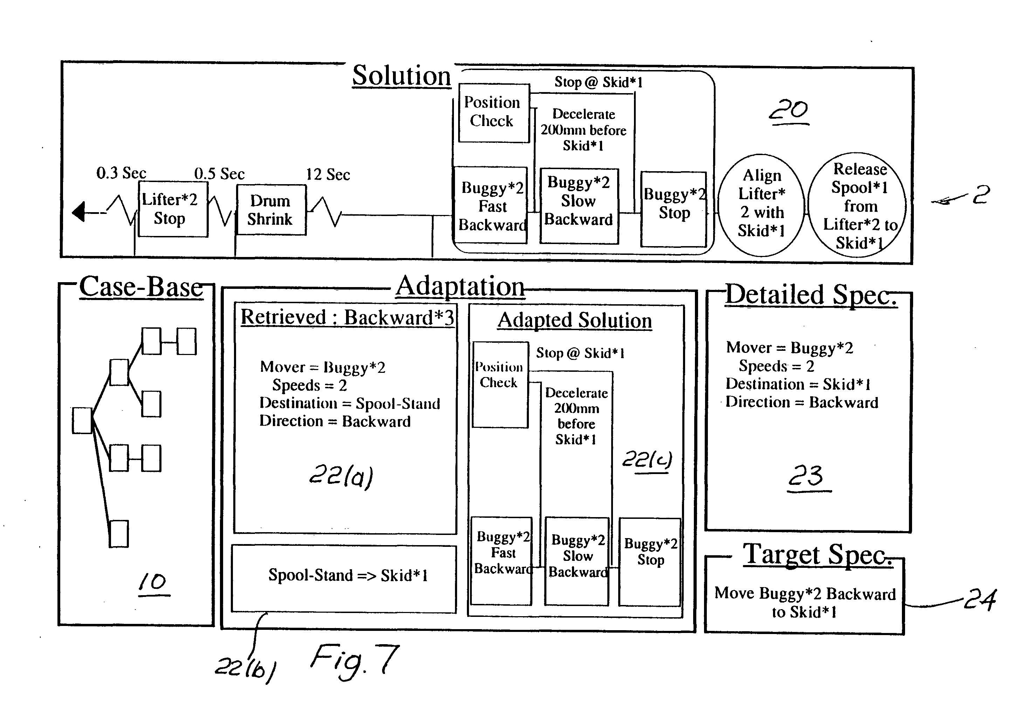

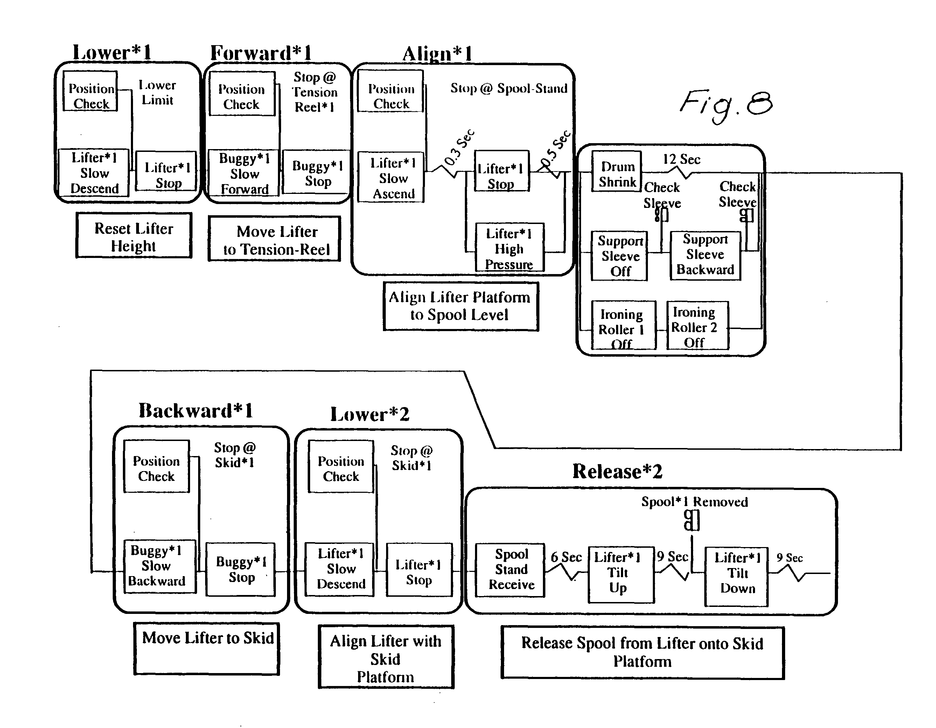

In particular, referring to Fig. 6, the second cycle of
the process is illustrated. In this case, the decomposition agent 29 has written the first link description to the target specification panel 24. This in turn causes the retrieval and adaptation of an appropriate case from the case-base 10. This is a detailed case, and thus the integration agent 28 must integrate the adapted solution into the target decomposable top level case at the appropriate place. This is shown in Fig. 6 in which the adapted solution shown in the panel 22(c) has been written to the solution panel 20.

It is worth noting that originally the detailed case Lower*1 was linked to Unload*1. However, the retrieval operations of this cycle return to the detailed case Lower*4 since it fits the target situation better than Lower*1 does. Thus, clearly the use of link descriptions adds greater flexibility to the process, relieving the adaptation problem somewhat. These advantages would be clearly understood if one considers what would have happened if there was a direct link employed to specify the component detailed cases of the top level cases.

Referring now to Fig. 7, the k'th cycle is illustrated in which an appropriate detailed case is retrieved as in the first cycle. However, a direct match was not achieved and thus detailed case adaptation must be carried out. As in the case of adapting the initial top level case, a rudimentary direct mapping form of adaptation is carried out to rectify the discrepancies between the retrieved detailed case and the target specification, namely, the destination of the movement action is changed from spool-stand to Skid*1. The adapted solution is then integrated into the solution panel 20.

An example final solution is shown in Fig. 8. It will be appreciated that this solution is suitable for carrying out the task which is described by the target specification.

It will be appreciated that the process of the invention allows for automatic design in an efficient manner by operating an electronic processing apparatus. This is achieved because the apparatus makes use of existing cases, and because a solution is developed in successive refinement cycles. Further, the manner in which existing cases are utilised is extremely efficient, for several reasons. One reason is the manner in which the case-base is constructed in both a taxonomic and a partonomic structure. The taxonomic structure allows for fast retrieval of a case, while the partonomic structure allows for flexibility in linking of decomposable top level cases to detailed cases so that the amount of adaptation required is kept to a minimum. It will be appreciated that it is only during adaptation that a user may be required to take part in an interactive inputting session, and the partonomic structure of the case-base reduces this to a minimum. The manner in which the cycles are invoked may vary. For example, where there are additional layers to the decomposable top level case and the detailed level cases, all detailed cases may be retrieved for a particular top level before the processors input the next top level case to the target specification. Alternatively, the processors may not go to a lower level for a case until all other cases have been brought to the same level.

It will also be appreciated that the successive refinement cycles are carried out in a well controlled manner because independent processors are used, the links between stages of a cycle being via the memory circuit. This leads to effective control because of simplicity.

Many of the advantages of the invention arise primarily because of the combination of the construction of memory circuit and "self-activation" agent control. Use of the memory circuit in this manner provides for very effective and efficient communication between agents in carrying out the process.

The invention is not limited to the embodiments hereinbefore described, but may be varied in construction and detail.

## Claims

1. An automatic case-based design process of the type comprising storing design data on a case-base in a memory circuit, preparing a target specification defining an item to be designed, writing the target specification to the memory circuit, automatically locating an address for a case and retrieving a closest fitting case in the case-base and adapting the retrieved case to the target specification to provide a solution,
**characterised by**,
the memory circuit comprising a plurality of panels (19 to 24) at least some of said panels (20 to 24) being for the temporary storage of data, and at least some of said panels (20 to 24) having each at least one processing agent (25 to 30) associated with them,
writing of data into one of said panels causing the triggering of the at least one associated processing agent,
initialising the process by writing a target specification defining an item to be designed to a predetermined panel (24), whereby a case is retrieved from the case-base, and written to another panel (22)
and by carrying out successive cycles of adapting said case (14) and rewriting the adapted case to another panel until the target solution is achieved.

2. A process as claimed in claim 1, where in cases (14) of the case-base have a partonomic, decomposable, structure formed of link descriptions (14(a)-14(g)), and the step of writing a target specification of an item involves writing a link description (14(a)-14(g)) of a retrieved and adapted decomposable case.

3. A process as claimed in claim 2, wherein the memory circuit (2) comprises an adaptation panel (22) to which the adapted cases are written, and a solution panel (20), and the adapted case is integrated with other parts of the target solution after said adapted case is written to the adaptation panel (22).

4. A process as claimed in any preceding claim, wherein the case-base (10) has a taxonomic structure, and the step of automatically determining an address for a case comprises the sub-step of referencing classification features of the target specification.

5. A process as claimed in claim 4, wherein cases (14) in the case-base (10) have a partonomic structure, and there is a further sub-step of referencing internal features (13) of the target specification to select a closest-match case for retrieval.

6. A process as claimed in any preceding claim, wherein the step of writing the retrieved case (14) to the panel (22) comprises the sub-steps of automatically identifying differences between the retrieved case and the target specification, and writing the differences as mapping links to a panel (22(b)) of the memory circuit (2) for reference during adaptation.

7. A process as claimed in claim 6, comprising the sub-step of, for each mapping link describing a discrepancy between a target specification and a retrieved case, identifying a pre-stored adaptation module for adaptation of the case for that discrepancy.

8. A process as claimed in any preceding claim, wherein the step of writing a target specification to the predetermined panel (24) comprises the sub-steps of receiving from a user and writing a decomposable target specification to a partitioned section (24) of the memory circuit (2), and subsequently automatically analysing the decomposable target specification and writing the resultant detailed target specification to another partitioned section (23) of the memory circuit (2), the detailed target specification being subsequently used in the design process.

9. A process as claimed in any preceding claim comprising the further step of automatically updating the case-base (10) with the target solution.

10. An automatic case-based design apparatus of the type comprising:
a memory circuit for storing design data on a case-base,
means for generating a target specification for defining an item to be designed and storing it in the memory circuit;
a retrieval processor for automatically determining an address for a case in the case-base by reference to the target specification in the memory circuit and retrieving the closest fitting case,
an adaptation processor for adapting the retrieved case into conformity with the target specification,
**characterised by**,
the memory circuit comprising a plurality of panels (19 to 24) at least some of said panels (20 to 24) being for the temporary storage of data, and at least some of said panels (20 to 24) having each at least one processing agent (25 to 30) associated with them,
by means for causing the triggering of the at least one processing agent when data is written into the associated one of said panels,
means for initialising the process by writing a target specification defining an item to be designed to a predetermined panel (24), whereby a case is retrieved from the case-base, and written into another panel (22),
and by means for carrying out successive cycles of adapting said case (14) and rewriting the adapted case to another panel until the target solution is achieved.

11. An apparatus as claimed in claim 10 further comprising a decomposition processor (29) comprising means for reading a portion of the solution in the panel (20) of the memory circuit (2), and writing said portion to a target specification panel (24) of the memory circuit (2) so that a further cycle of retrieval and adaptation is initiated.

12. An apparatus as claimed in claim 10 or 11 further comprising an analysis processor (25) comprising means for reading a decomposable high-level target specification to generate a detailed target specification, and means for writing the detailed target specification to a panel (24).

13. An apparatus as claimed in any of claims 10 to 12 further comprising a learning processor (30) comprising means for updating the case-base (10) by reading the adapted case and writing it to the case-base (10).

## Patentansprüche

1. Automatisches fallbezogenes Konstruktionsverfahren, das folgendes umfasst: Speichern von Konstruktionsdaten auf einer Fallbank in einer Speicherschaltung, Vorbereiten einer Zielspezifikation, die einen zu konstruierenden Gegenstand definiert, Schreiben der Zielspezifikation auf die Speicherschaltung, automatisches Suchen einer Adresse für einen Fall und Einlesen eines nächstliegenden Falls in die Fallbank und Anpassen des eingelesenen Falls an die Zielspezifikation zur Bereitstellung einer Lösung, **dadurch gekennzeichnet, dass**:
die Speicherschaltung eine Mehrzahl von Feldern (19 bis 24) umfasst, wobei wenigstens einige der genannten Felder (20 bis 24) zur vorübergehenden Speicherung von Daten dienen und wobei mit wenigstens einigen der genannten Felder (20 bis 24) jeweils wenigstens ein Verarbeitungsagent (25 bis 30) assoziiert ist,
Schreiben von Daten in eines der genannten Felder, wodurch eine Auslösung des wenigstens einen assoziierten Verarbeitungsagenten bewirkt wird,
Initialisieren des Verfahrens durch Schreiben einer einen zu konstruierenden Gegenstand definierenden Zielspezifikation auf ein vorbestimmtes Feld (24), so dass ein Fall aus der Fallbank gelesen und auf ein anderes Feld (22) geschrieben wird,
und Durchführen aufeinanderfolgender Zyklen aus Anpassen des genannten Falls (14) und Neuschreiben des angepassten Falls auf ein anderes Feld, bis die Ziellösung erreicht ist.

2. Verfahren nach Anspruch 1, bei dem Fälle (14) aus der Fallbank eine partonomische, zerlegbare Struktur haben, die aus Verkettungsbeschreibungen (14(a)-14(g)) besteht, und der Schritt des Schreibens einer Zielspezifikation eines Gegenstandes das Schreiben einer Verkettungsbeschreibung (14(a)-14(g)) eines eingelesenen und angepassten zerlegbaren Falls beinhaltet.

3. Verfahren nach Anspruch 2, bei dem die Speicherschaltung (2) ein Anpassungsfeld (22), auf das die angepassten Fälle geschrieben werden, und ein Lösungsfeld (20) umfasst, und bei dem der angepasste Fall nach dem Schreiben des genannten angepassten Falls auf das Anpassungsfeld (22) mit anderen Teilen der Ziellösung integriert wird.

4. Verfahren nach einem der vorherigen Ansprüche, bei dem die Fallbank (10) eine taxonomische Struktur hat und der Schritt zum automatischen Bestimmen einer Adresse für einen Fall den Unterschritt des Referenzierens von Klassifizierungsmerkmalen der Zielspezifikation umfasst.

5. Verfahren nach Anspruch 4, bei dem Fälle (14) in der Fallbank (10) eine partonomische Struktur haben und bei dem ein weiterer Unterschritt des Referenzierens interner Merkmale (13) der Zielspezifikation vorhanden ist, um einen nächstliegenden Fall zum Einlesen auszuwählen.

6. Verfahren nach einem der vorherigen Ansprüche, bei dem der Schritt des Schreibens des eingelesenen Falls (14) auf das Feld (22) die Unterschritte des automatischen Identifizierens von Differenzen zwischen dem eingelesenen Fall und der Zielspezifikation sowie des Schreibens der Differenzen als Abbildungsverkettungen auf ein Feld (22(b)) der Speicherschaltung (2) als Referenz bei der Anpassung umfasst.

7. Verfahren nach Anspruch 6, umfassend den Unterschritt des Identifizierens für jede Abbildungsverkettung, die eine Diskrepanz zwischen einer Zielspezifikation und einem eingelesenen Fall beschreibt, eines vorgespeicherten Anpassungsmoduls zum Anpassen des Falls für diese Diskrepanz.

8. Verfahren nach einem der vorherigen Ansprüche, bei dem der Schritt des Schreibens einer Zielspezifikation auf das vorbestimmte Feld (24) die Unterschritte des Empfangens einer zerlegbaren Zielspezifikation von einem Benutzer und des Schreibens derselben auf eine partitionierte Sektion (24) der Speicherschaltung (2) und des nachfolgenden automatischen Analysierens der zerlegbaren Zielspezifikation und des Schreibens der resultierenden detaillierten Zielspezifikation auf eine andere partitionierte Sektion (23) der Speicherschaltung (2) umfasst, wobei die detaillierte Zielspezifikation nachfolgend in dem Konstruktionsverfahren angewendet wird.

9. Verfahren nach einem der vorherigen Ansprüche, umfassend den weiteren Schritt des automatischen Aktualisierens der Fallbank (10) mit der Ziellösung.

10. Automatische fallbezogene Konstruktionsvorrichtung, die folgendes umfasst:
eine Speicherschaltung zum Speichern von Konstruktionsdaten auf einer Fallbank,
ein Mittel zum Vorbereiten einer Zielspezifikation zum Definieren eines zu konstruierenden Gegenstands und zum Speichern desselben in der Speicherschaltung,
einen Retrievalprozessor zum automatischen Suchen einer Adresse für einen Fall in der Fallbank durch Bezugnahme auf die Zielspezifikation in der Speicherschaltung und zum Einlesen eines nächstliegenden Falls,
einen Anpassungsprozessor zum Anpassen des eingelesenen Falls an die Zielspezifikation, **dadurch gekennzeichnet, dass**:
die Speicherschaltung eine Mehrzahl von Feldern (19 bis 24) umfasst, wobei wenigstens einige der genannten Felder (20 bis 24) zur vorübergehenden Speicherung von Daten dienen und wobei mit wenigstens einigen der genannten Felder (20 bis 24) jeweils wenigstens ein Verarbeitungsagent (25 bis 30) assoziiert ist,
ein Mittel vorhanden ist, um eine Auslösung des wenigstens einen assoziierten Verarbeitungsagenten zu bewirken, wenn Daten in das assoziierte eine der genannten Felder geschrieben werden,
ein Mittel zum Initialisieren des Verfahrens durch Schreiben einer einen zu konstruierenden Gegenstand definierenden Zielspezifikation auf ein vorbestimmtes Feld (24) vorhanden ist, so dass ein Fall aus der Fallbank gelesen und auf ein anderes Feld (22) geschrieben wird,
und ein Mittel zum Durchführen aufeinanderfolgender Zyklen aus Anpassen des genannten Falls (14) und Neuschreiben des angepassten Falls auf ein anderes Feld vorhanden ist, bis die Ziellösung erreicht ist.

11. Vorrichtung nach Anspruch 10, ferner umfassend einen Zerlegungsprozessor (29), umfassend ein Mittel zum Lesen eines Teils der Lösung in das Feld (20) der Speicherschaltung (2) und zum Schreiben des genannten Teils auf ein Zielspezifikationsfeld (24) der Speicherschaltung (2), so dass ein weiterer Zyklus aus Einlesen und Anpassen eingeleitet wird.

12. Vorrichtung nach Anspruch 10 oder 11, ferner umfassend einen Analyseprozessor (25), umfassend ein Mittel zum Lesen einer zerlegbaren allgemeinen Zielspezifikation zum Erzeugen einer detaillierten Zielspezifikation und ein Mittel zum Schreiben der detaillierten Zielspezifikation auf ein Feld (24).

13. Vorrichtung nach einem der Ansprüche 10 bis 12, ferner umfassend einen Lernprozessor (30), umfassend ein Mittel zum Aktualisieren der Fallbank (10) durch Lesen des angepassten Falls und Schreiben desselben auf die Fallbank (10).

## Revendications

1. Procédé de conception automatique basé sur cas du type comprenant stocker des données conceptuelles dans une base de cas dans un circuit de mémoire, préparer une spécification cible définissant un article à concevoir, écrire la spécification cible au circuit de mémoire, localiser automatiquement une adresse pour un cas et extraire un cas le mieux adapté dans la base de cas et adapter le cas extrait à la spécification cible pour fournir une solution, **caractérisé par**,
le circuit de mémoire comprenant une pluralité de tableaux (19 à 24) au moins certains desdits tableaux (20 à 24) étant pour le stockage temporaire de données, et au moins certains desdits tableaux (20 à 24) ayant chacun au moins un agent de traitement (25 à 30) associé à eux,
écrire des données dans l'un desdits tableaux causant le déclenchement du au moins un agent de traitement associé,
initialiser le procédé en écrivant une spécification cible définissant un article à concevoir à un tableau prédéterminé (24), moyen par lequel un cas est extrait de la base de cas, et écrit à un autre tableau (22)
et en exécutant des cycles successifs d'adaptation dudit cas (14) et réécrivant le cas adapté à un autre tableau jusqu'à ce que la solution cible soit réalisée.

2. Procédé tel que revendiqué dans la revendication 1, dans lequel des cas (14) de la base de cas ont une structure partonomique, décomposable formée de descriptions de liaison (14(a)-14(g)), et l'étape consistant à écrire une spécification cible d'un article englobe écrire une description de liaison (14(a)-14(g)) d'un cas extrait et adapté décomposable.

3. Procédé tel que revendiqué dans la revendication 2, dans lequel le circuit de mémoire (2) comprend un tableau d'adaptation (22) auquel les cas adaptés sont écrits, et un tableau de solution (20) et le cas adapté est intégré à d'autres parties de la solution cible après que ledit cas adapté a été écrit au tableau d'adaptation (22).

4. Procédé tel que revendiqué dans l'une quelconque des revendications précédentes, dans lequel la base de cas (10) a une structure taxonomique, et l'étape consistant à déterminer automatiquement une adresse pour un cas comprend la sous-étape consistant à référencier des caractéristiques de classification de la spécification cible.

5. Procédé tel que revendiqué dans la revendication 4, dans lequel des cas (14) dans la base de cas (10) ont une structure partonomique, et il y a une autre sous-étape consistant à référencier des caractéristiques internes (13) de la spécification cible afin de sélectionner le cas le plus étroitement correspondant, pour extraction.

6. Procédé tel que revendiqué dans l'une quelconque des revendications précédentes, dans lequel l'étape consistant à écrire le cas extrait (14) au tableau (22) comprend les sous-étapes consistant à identifier automatiquement des différences entre le cas extrait et la spécification cible, et à écrire les différences comme des liens de représentation à un tableau (22(b)) du circuit de mémoire (2) pour référence durant l'adaptation.

7. Procédé tel que revendiqué dans la revendication 6, comprenant la sous-étape consistant à, pour chaque lien de représentation, décrire une divergence entre une spécification cible et un cas extrait, identifier un module d'adaptation pré-stocké pour l'adaptation du cas à cette divergence.

8. Procédé tel que revendiqué dans l'une quelconque des revendications précédentes, dans lequel l'étape consistant à écrire une spécification cible au tableau prédéterminé (24) comprend les sous-étapes consistant à recevoir d'un utilisateur et à écrire une spécification cible décomposable à une section subdivisée (24) du circuit de mémoire (2), et à analyser ensuite automatiquement la spécification cible décomposable et à écrire la spécification cible détaillée résultante à une autre section subdivisée (23) du circuit de mémoire (2), la spécification cible détaillée étant ensuite utilisée dans le procédé de conception.

9. Procédé tel que revendiqué dans l'une quelconque des revendications précédentes comprenant l'étape ultérieure consistant à actualiser automatiquement la base de cas (10) avec la solution cible.

10. Appareil de conception automatique basé sur cas du type comprenant :
un circuit de mémoire pour stocker des données conceptuelles dans une base de cas,
des moyens pour générer une spécification cible pour définir un article à concevoir et le stocker dans le circuit de mémoire;
un processeur d'extraction pour déterminer automatiquement une adresse pour un cas dans la base de cas par référence à la spécification cible dans le circuit de mémoire et extraire le cas le mieux adapté;
un processeur d'adaptation pour adapter le cas extrait en conformité avec la spécification cible, **caractérisé par**,
le circuit de mémoire comprenant une pluralité de tableaux (19 à 24) au moins certains desdits tableaux (20 à 24) étant pour le stockage temporaire de données, et au moins certains desdits tableaux (20 à 24) ayant chacun au moins un agent de traitement (25 à 30) associé à eux,
un moyen pour causer le déclenchement du au moins un agent de traitement lorsque des données sont écrites dans le tableau associé desdits tableaux,
un moyen pour initialiser le procédé en écrivant une spécification cible définissant un article à concevoir à un tableau prédéterminé (24), moyen par lequel un cas est extrait de la base de cas, et écrit à un autre tableau (22)
et un moyen pour exécuter des cycles successifs d'adaptation dudit cas (14) et réécrire le cas adapté à un autre tableau jusqu'à ce que la solution cible soit réalisée.

11. Appareil tel que revendiqué dans la revendication 10 comprenant en outre un processeur de décomposition (29) comprenant des moyens pour lire une partie de la solution dans le tableau (10) du circuit de mémoire (2), et écrire ladite partie à un tableau de spécification cible (24) du circuit de mémoire (2) de sorte qu'un autre cycle d'extraction et d'adaptation est lancé.

12. Appareil tel que revendiqué dans la revendication 10 ou 11 comprenant en outre un processeur d'analyse (25) comprenant un moyen pour lire un spécification cible décomposable de haut niveau afin de générer une spécification cible détaillée, et un moyen pour écrire la spécification cible détaillée à un tableau (24).

13. Appareil tel que revendiqué dans l'une quelconque des revendications 10 à 12 comprenant en outre un processeur d'apprentissage (30) comprenant des moyens pour actualiser la base de cas (10) en lisant le cas adapté et en l'écrivant à la base de cas (10).
